(19) Europäisches Patentamt
European Patent Office
Office européen des brevets

(11) EP 4 481 791 A1

(12) EUROPÄISCHE PATENTANMELDUNG

(43) Veröffentlichungstag:
25.12.2024  Patentblatt 2024/52

(21) Anmeldenummer: 24184073.5

(22) Anmeldetag: 24.06.2024

(51) Internationale Patentklassifikation (IPC):
H01J 37/32 (2006.01)     H05B 6/64 (2006.01)

(52) Gemeinsame Patentklassifikation (CPC):
H01J 37/32201; H05B 6/64

(84) Benannte Vertragsstaaten:
AL AT BE BG CH CY CZ DE DK EE ES FI FR GB GR HR HU IE IS IT LI LT LU LV MC ME MK MT NL NO PL PT RO RS SE SI SK SM TR
Benannte Erstreckungsstaaten:
BA
Benannte Validierungsstaaten:
GE KH MA MD TN

(30) Priorität: 22.06.2023  DE 102023116401
08.05.2024  EP 24174871

(71) Anmelder: KHS GmbH
44143 Dortmund (DE)

(72) Erfinder:
• Meier, M. Sc., Vinzent
44143 Dortmund (DE)
• Lengefeld, Jan
44143 Dortmund (DE)
• Kytzia, Sebastian
44143 Dortmund (DE)

(74) Vertreter: Andrejewski - Honke
Patent- und Rechtsanwälte Partnerschaft mbB
An der Reichsbank 8
45127 Essen (DE)

(54) **VERFAHREN ZUM BETRIEB EINES MAGNETRONS UND MAGNETRON**

(57)  Die Erfindung betrifft ein Verfahren zum Betrieb eines Magnetrons (1) mit einem durch eine Anode (2) umschlossenen Hohlraum (3), mit einer in dem Hohlraum (3) angeordneten Kathode (5), welche eine Heizeinrichtung (4), insbesondere einen Heizdraht aufweist. Ferner ist eine regelbare Spannungsquelle (6) vorgesehen, welche an die Heizeinrichtung (4) angeschlossen ist sowie eine Steuerung (8). Erfindungsgemäß wird ein Sollwert ($U_{soll}$) für eine an der Heizeinrichtung (4) anliegende Heizspannung (U) bestimmt und die Steuerung (8) steuert die Spannungsquelle (6) derart an, dass an der Heizeinrichtung (4) der Sollwert ($U_{soll}$) der Heizspannung (U) anliegt.

<u>Fig. 1</u>

EP 4 481 791 A1

**Beschreibung**

Die Erfindung betrifft ein Verfahren zum Betrieb eines Magnetrons mit einem durch eine Anode umschlossenen Hohlraum, mit einer in dem Hohlraum angeordneten Kathode, welche eine Heizeinrichtung, insbesondere einen Heizdraht, aufweist, mit einer regelbaren Spannungsquelle, welche an die Heizeinrichtung angeschlossen ist und mit einer Steuerung. Die Erfindung betrifft auch ein derartiges Magnetron.

Magnetrons werden als energieeffiziente und kostengünstige Quellen von Mikrowellenstrahlung eingesetzt. Die so erzeugte Mikrowellenstrahlung findet beispielsweise zur Energieübertragung Verwendung. Dabei lässt sich diese unter anderem im Rahmen eines Plasmaprozesses zum Einkoppeln von Heizleistung in das Plasma und/oder zur Anregung von chemischen und physikalischen Abscheidungsprozessen aus dem Plasma an eine zu behandelnde und/oder beschichtende Oberfläche genutzt werden.

Zum grundsätzlichen Aufbau eines Magnetrons gehört eine Anode, welche einen Hohlraum umgibt sowie eine innerhalb des Hohlraums angeordnete Kathode. Die Kathode wird durch - insbesondere durch die Heizeinrichtung vermittelte - Hitzeeinwirkung dazu angeregt, Elektronen abzusondern. Man spricht insbesondere auch von einer sogenannten Glühkathode.

Zwischen der Kathode und der Anode wird eine Hochspannung angelegt, welche die austretenden Elektronen in Richtung der Anode beschleunigt. Die Flugbahn dieser Elektronen wird durch ein Magnetfeld gekrümmt. Insbesondere ist die Kathode dabei koaxial von der Anode umgeben, wobei die Magnetfeldlinien ebenfalls im Wesentlichen axial verlaufen.

Die Formgebung der Anode wird derart gewählt, dass aufgrund der Elektronenbewegung elektromagnetische Resonanzen auftreten. Die so erzeugten Mikrowellen können über einen in der Anode ausgebildeten Ausgang ausgekoppelt und einer Verwendung zugeführt werden.

Die Herstellungskosten eines Magnetrons sind insbesondere aufgrund des verwendeten Kathodenmaterials hoch. Ein wesentlicher limitierender Faktor für die Lebensdauer eines Magnetrons besteht in der Abnutzung der Kathode. Aufgrund der Aufheizung der Kathode und des aus ihr austretenden Elektronenstroms wird das Kathodenmaterial abgetragen und/oder so verändert, dass die Funktionsfähigkeit mit der Zeit reduziert wird. Ab einem gewissen Abnutzungsgrad ist die Kathode nicht mehr zu verwenden und muss ausgetauscht werden. Bei diesem Abnutzungsgrad kommt die Elektronenemission nicht mehr zustande und das Magnetron kann nicht mehr zünden.

Vor diesem Hintergrund liegt der Erfindung die Aufgabe zugrunde, die Lebensdauer eines Magnetrons, insbesondere für die Verwendung in einem Plasmaprozess, vorzugsweise einem Plasma-Beschichtungsprozess, zu verlängern. Gegenstand der Erfindung und Lösung dieser Aufgabe ist ein Verfahren nach Anspruch 1 sowie ein Magnetron nach Anspruch 17 und eine Behälterbeschichtungsanlage nach Anspruch 22. Bevorzugte Ausgestaltungen sind in den abhängigen Unteransprüchen angegeben.

Ausgehend von dem gattungsgemäßen Verfahren ist erfindungsgemäß vorgesehen, dass ein Sollwert für eine an der Heizeinrichtung anliegende Heizspannung bestimmt wird und dass die Steuerung die Spannungsquelle derart ansteuert, dass an der Heizeinrichtung der Sollwert für die Heizspannung anliegt. Der Erfindung liegt dabei insbesondere die Erkenntnis zugrunde, dass bei einer spannungsgeregelten Ansteuerung der Heizeinrichtung die Lebensdauer des Magnetrons deutlich verbessert werden kann.

Die Heizeinrichtung weist vorzugsweise zumindest zwei elektrische Eingänge auf, welche durch zumindest eine Versorgungsleitung mit der Spannungsquelle verbunden sind. Die an der Heizeinrichtung abfallende Heizspannung wird dabei vorzugsweise unmittelbar an den Eingängen gemessen. Die Heizspannung kann ohne Beschränkung der Erfindung als Gleich- oder Wechselspannung ausgebildet sein. Beim Vorhandensein von Wechselspannungsanteilen ist dabei insbesondere auf die effektive Spannung abzustellen.

Zweckmäßigerweise ist die Heizeinrichtung als sogenannter Heizdraht oder Heizwendel ausgebildet. Dabei handelt es sich um eine elektrische Leitung, welche die Eingänge der Heizeinrichtung miteinander verbindet und eine gegenüber der Versorgungsleitung größeren ohmschen Widerstand aufweist. Beim Anlegen der Heizspannung kommt ein Stromfluss zustande, welcher aufgrund der Widerstands-Verhältnisse überwiegend in der Heizeinrichtung in Wärme umgesetzt wird.

Bei einem positiven Temperaturkoeffizienten der Heizeinrichtung hat die erfindungsgemäße Spannungs-gesteuerte Regelung hat gegenüber einer stromgeführten Steuerung zusätzlich den Vorteil, dass bei einer höheren Temperatur der Widerstand steigt und infolgedessen bei konstanter Spannung der Stromfluss und die elektrische Heizleistung reduziert werden. Dies vereinfacht die Regelung der Glühkathode und trägt zu einer erhöhten Lebensdauer bei.

Vorzugsweise ist vorgesehen, dass die Steuerung eine Einheit zur Erfassung der Betriebszeit T des Magnetrons und/oder der Heizeinrichtung aufweist und dass der Sollwert in Abhängigkeit von der Betriebszeit bestimmt wird. Im Rahmen der Erfindung wurde festgestellt, dass für eine optimale Ausnutzung der Lebensdauer des Magnetrons zu unterschiedlichen Zeitpunkten des Lebenszyklus' unterschiedliche Strategien vorteilhaft sind. Während zu Beginn der Lebensdauer die unverbrauchte Kathode auch mit einer geringen Hitze-Stimulation durch die Heizeinrichtung zu einer zuverlässigen ElektronenEmission fähig ist, muss bei zunehmender Abnutzung (zu einem späteren Zeitpunkt des Lebenszyklus') mitunter eine höhere Heizspannung angelegt werden, also der Sollwert gesteigert werden. Zwar könnte das Magnetron auch mit einer dauerhaft erhöhten Heizspannung versorgt werden, jedoch hätte dies einen erhöhten Verschleiß zu Beginn der Lebensdauer zur Folge. Daher ist eine über die Lebensdauer variierende, insbesondere in Abhängigkeit von der Lebensdauer bestimmte Soll-Spannung von Vorteil.

Besonders bevorzugt ist vorgesehen, dass der Sollwert von einem Minimalwert $U_{min}$ (minimale Heizspannung) ausgehend festgelegt wird. Dieser Minimalwert ist vorzugsweise so festgelegt, dass bei einer unverbrauchten, fabrikneuen Kathode ein Zünden des Magnetrons möglich ist. Bevorzugt beträgt dieser etwa 1 V. Von einem Zünden spricht man insbesondere dann, wenn die zwischen der Anode und der Kathode anliegende (Hoch-)Spannung - bei der durch die Heizeinrichtung bei Betrieb mit der Heizspannung anfallenden Heizleistung - ausreicht, um eine stabile (Glüh-)Emission und Oszillation von Elektronen zu ermöglichen, sodass das Magnetron in der vorgesehenen Weise Mikrowellen herstellen kann. Bei einem handelsüblichen Magnetron - z. B. Typ 2M 121A der Firma Hitachi - liegt der Minimalwert bevorzugt in einem Bereich zwischen 1 V und 10 V.

Gemäß einer bevorzugten Ausgestaltung der Erfindung ist vorgesehen, dass der Sollwert zumindest abschnittsweise als lineare Funktion der Betriebszeit T bestimmt wird. Insbesondere liegt der lineare Verlauf in einem Zeitintervall zwischen einem ersten Zeitpunkt $T_1$ und einem zweiten Zeitpunkt $T_2$. Der erste Zeitpunkt $T_1$ liegt vorzugsweise zwischen null Betriebsstunden und 1.000 Betriebsstunden, während der zweite Zeitpunkt $T_2$ vorzugsweise zwischen 2.000 Betriebsstunden und 5.000 Betriebsstunden liegt. Dabei steigt der Sollwert $U_{Soll}$ von dem ersten Zeitpunkt $T_1$ von einem ersten Spannungswert $U_1$ zu einem zweiten Spannungswert $U_2$ am zweiten Zeitpunkt $T_2$ ein. Der Spannungswert $U_2$ ist dabei größer als der Spannungswert $U_1$. Der erste Spannungswert $U_1$ kann dabei insbesondere dem Minimalwert $U_{min}$ entsprechen. Der momentane Sollwert U(T) berechnet sich dabei insbesondere als lineare Interpolation nach der folgenden Formel:

$$U(T) = U_1 + \frac{U_2 - U_1}{T_2 - T_1}(T - T_1) \ \forall \ T \in [T_1; T_2]$$

Alternativ oder zusätzlich kann vorgesehen sein, dass der Sollwert nach dem Eintreten eines auslösenden Ereignisses (Auslöser) entweder in bereits vorher festgelegter Weise erhöht oder alternativ überprüft und bedarfsgerecht erhöht wird.

Im ersten Fall kann insbesondere vorgesehen sein, dass der Sollwert um einen festgelegten Wert, insbesondere zwischen 1V und 10 V, z. B. 0,1V inkrementiert wird. Ebenso ist denkbar, dass der Sollwert gemäß einer vorher bestimmten Formel festgelegt wird. Hierdurch ergibt sich ein Stufenverlauf des Sollwertes über die Betriebsdauer.

Bei dem Auslöser kann es sich insbesondere um einen externen Auslöser, insbesondere eine Benutzereingabe und/oder eine externe Ansteuerung handeln. Die Steuerung des Magnetrons ist dabei dazu eingerichtet, eine externe Anforderung zur Erhöhung des Sollwerts für die Heizspannung vorzunehmen. Eine solche Anforderung kann insbesondere dann ergehen, wenn gewisse Betriebsparameter und/oder Arbeitsergebnisse nicht den Anforderungen entsprechen.

Alternativ oder zusätzlich kann der Auslöser auch das Erreichen eines Schwellenwerts der Betriebszeit (des Magnetrons und/oder der Heizeinrichtung) sein. Dadurch wird in vorher bestimmten Zeitintervallen der Schwellenwert angehoben und/oder eine Überprüfung desselben durchgeführt, um eine bedarfsgerechte Erhöhung zu ermöglichen. Ebenso ist es denkbar, dass der Auslöser das Erreichen eines Zeitintervalls an Betriebszeit seit der letzten Überprüfung bzw. der letzten Erhöhung des Sollwerts ist.

Besonders bevorzugt wird ein Stromfluss zwischen der Anode und der Kathode (Anodenstrom) erfasst. Der Auslöser kann dabei insbesondere das Unterschreiten eines Schwellenwerts beim Anodenstrom sein. Ein Abfall bzw. ein vollständiges Zusammenbrechen des Anodenstroms deutet auf ein nicht ausreichendes Zünden des Magnetrons hin. In diesem Fall ist ein Funktionieren nicht gewährleistet. Infolgedessen muss die Heizspannung (der Sollwert der Heizspannung) erhöht werden, um eine stabile Glühemission der Kathode zu ermöglichen.

Besonders bevorzugt ist im Rahmen der Überprüfung vorgesehen, dass der Sollwert sukzessive erhöht wird, bis der Anodenstrom einen Schwellenwert erreicht oder überschreitet. Insbesondere ist dabei ein Inkrement zwischen 0,01 V und 0,1 V vorgesehen. Durch das sukzessive Inkrementieren des Sollwerts wird gewährleistet, dass dieser nur in dem Ausmaß erhöht wird, wie dies zur Sicherstellung einer zuverlässigen Magnetron-Zündung erforderlich wird. Unnötiger Verschleiß wird dadurch vermieden. Auch ist im Rahmen der Erfindung insbesondere vorgesehen, dass eine Erhöhung des Sollwerts nur dann erfolgt, wenn zuvor zumindest eine fehlgeschlagene Zündung des Magnetrons festgestellt wurde. Zweckmäßigerweise kann damit auf übermäßige bzw. unnötige Verschleiß-verstärkende Erhöhungen verzichtet werden.

Insbesondere ist vorgesehen, dass der Sollwert in der Steuerung gespeichert und zwischen zwei aufeinanderfolgenden Überprüfungen verwendet wird. In diesem Zeitintervall ist der Sollwert damit konstant.

Ebenso ist es denkbar nach Eintritt eines Auslösers - insbesondere durch Zeitablauf ausgelösten Überprüfungen - den Sollwert zunächst zu reduzieren. Dies kann insbesondere um einen Betrag zwischen 0,1V und 5 V, insbesondere ca. 1 V erfolgen. Auch ist es denkbar, den Sollwert sukzessive zu dekrementieren, bis ein Zündfehler des Magnetrons festgestellt wird. Anschließend wird der Sollwert wieder erhöht, bis die Zündung erfolgt. Hierdurch kann die maximale Ausnutzung der Lebensdauer eines Magnetrons ausgereizt werden.

Vorzugsweise ist vorgesehen, dass der Sollwert nicht unter die Minimalspannung reduziert wird. Ebenso ist vorzugsweise vorgesehen, dass der Sollwert nicht über eine maximale Spannung $U_{max}$ (maximale Heizspannung) erhöht wird. Diese maximale Heizspannung markiert insbesondere die Grenze der wirtschaftlichen und/oder verfahrenstechnisch sicheren Betriebsparameter. Die maximale Heizspannung beträgt insbesondere zwischen 1 V und 10 V.

Besonders bevorzugt ist vorgesehen, dass das Magnetron bei Erreichen Maximalwerts durch den Sollwert abgeschaltet wird. Dies ist insbesondere der Fall, wenn bei bereits auf den Maximalwert $U_{max}$ eingestelltem Sollwert für die Heizspannung der Schwellenwert für den Anodenstrom unterschritten wird - also ein Zündfehler des Magnetrons auftritt. Dasselbe gilt für den Fall, dass der Sollwert zwar den Maximalwert $U_{max}$ zwar noch nicht erreicht hat, eine (vorgesehene) weitere Inkrement Regierung den Maximalwert $U_{max}$ überschreiten würde. In diesen Fällen ist das Magnetron als defekt einzustufen und auszutauschen. Hierzu wird das Magnetron abgeschaltet, ein Fehlersignal gesendet und/oder die Produktion unterbrochen.

Besonders bevorzugt lässt sich das Verfahren im Rahmen einer Plasmabeschichtung einsetzen. Hierzu ist zweckmäßigerweise vorgesehen, dass das Magnetron über einen Ausgang Mikrowellenstrahlung an ein Plasma, insbesondere für ein Plasmabeschichtungsverfahren abgibt. Bei dem Plasmabeschichtungsverfahren handelt es sich ganz besonders bevorzugt um eine Plasmabeschichtung von Behältern, wie beispielsweise Flaschen. Anders ausgedrückt betrifft die Erfindung auch ein Plasmabeschichtungsverfahren von Behältern.

Bei dem Plasmabeschichtungsverfahren handelt es sich insbesondere um eine Plasmabeschichtungs-Technik namens PICVD - Plasma induced oder impulse chemical vapor deposition. Dabei wird in einer Reaktionskammer ein zu beschichtender Behälter, vorzugsweise Kunststoffbehälter, insbesondere eine Flasche aus PET, aufgenommen und ein Reaktionsgas, insbesondere gebildet aus Monomeren und Trägergasen, eingeleitet. Durch das zuvor beschriebene Magnetron wird durch Anlegen einer Hochspannung an Kathode und Anode Mikrowellenenergie erzeugt, welche in die Reaktionskammer eingeleitet wird. Durch diese wird das Reaktionsgas in einen Plasmazustand überführt. Die Bestandteile des dabei zumindest teilweise ionisierten Reaktionsgases - insbesondere die Monomere - lagern sich dann an einer Oberfläche des Behälters als Beschichtung ab. Hierdurch lassen sich insbesondere stofffremde Beschichtungen, wie beispielsweise aus Siliziumdioxid aufbringen.

Vorzugsweise wird die Hochspannung in Pulsen angelegt, sodass gepulste Mikrowellenenergie erzeugt und in dem Reaktionsgas ein gepulstes Plasma gezündet wird. Durch das Pulsmuster - die Pulslänge, die Pulshöhe und/oder den zeitlichen Abstand - der Pulse lassen sich die Eigenschaften der erzeugten Beschichtung einstellen.

Vorzugsweise wird das Plasmabeschichtungsverfahren mit einem in der Reaktionskammer herrschenden Unterdruck von insbesondere nicht mehr als 200 mbar, bevorzugt nicht mehr als 100 mbar, besonders bevorzugt nicht mehr als 50 mbar durchgeführt. Dies ermöglicht bzw. erleichtert die Zündung eines Plasmas in der Reaktionskammer. Besonders bevorzugt wird diese vor dem Einleiten des Reaktionsgases evakuiert.

Im Rahmen der Erfindung meint ein Puls das Anlegen der Hochspannung für eine Zeitdauer (Pulslänge) von nicht mehr als 50 ms. Es ist vorzugsweise vorgesehen, dass die Pulse jeweils eine Pulslänge von nicht mehr als 15 ms, vorzugsweise nicht mehr 10 ms, besonders bevorzugt nicht mehr als 7 ms, insbesondere nicht mehr als 5 ms aufweisen.

Auf einen Puls der Hochspannung folgt eine auch als Pause bezeichnete Phase ohne Hochspannung, Mikrowellenstrahlung, Plasmazündung mit einer Pausenlänge von vorzugsweise zumindest der halben Pulslänge, insbesondere der ganzen Pulslänge. Besonders bevorzugt werden Pulsfolgen aus mehreren gleichartigen Pulsen und mehreren dazwischenliegenden gleichartigen Pausen gebildet. Bevorzugt weist eine Pulsfolge zumindest drei Pulse, besonders bevorzugt zumindest zehn Pulse auf, welche sich mit Pausen abwechseln. Die Anzahl der Pulse in einer Pulsfolge beträgt weiterhin vorzugsweise nicht mehr als 1.000, besonders bevorzugt nicht mehr als 500.

Bevorzugt beträgt die Periode der Pulse - die Summe aus Pulslänge und Pausenlänge - nicht mehr als 75 ms, insbesondere nicht mehr als 65 ms.

Das Verhältnis innerhalb einer Pulsfolge zwischen Pulslänge und Pausenlänge - auch als Tastverhältnis bezeichnet - beträgt vorzugsweise zumindest 1:1, besonders bevorzugt zumindest 1:4, insbesondere zumindest 1:100. Dabei kombinieren sich sehr hohe Momentanleistungen des Magnetrons während der Pulse mit dazwischenliegenden längeren Pausen, sodass für den Verschleiß des Magnetrons und die Belastung der gesamten Vorrichtung kritische Durchschnittsleistungen nicht überschritten werden. Zusätzlich erhöht der erfindungsgemäße Betrieb des Magnetrons dessen Lebensdauer im Pulsbetrieb erheblich.

Die konkrete Ausgestaltung einer Folge von Pulsen - insbesondere mit ihrer Gesamtlänge, den einzelnen Pulslängen, dem Tastverhältnis bzw. der Pulsanzahl, der Pulshöhe (der Hochspannung) und der damit gekoppelten momentanen Mikrowellenleistung - wird auch als Pulsmuster bezeichnet.

Besonders bevorzugt ist vorgesehen, dass das Magnetron mit einem gleichmäßigen Pulsmuster betrieben wird. Ein solches Pulsmuster beschreibt dabei eine Gruppe von mehreren aufeinanderfolgenden Pulsen identischer Länge, unterbrochen durch mehrere (untereinander) gleichlange Pausen.

Gemäß einer bevorzugten Variante weisen die Pulse hinsichtlich ihrer Höhe dieselbe Hochspannung auf. Es ist jedoch auch denkbar, dass diese einen insbesondere ansteigenden oder einen abfallenden Spannungsverlauf während eines Pulsmusters durchlaufen.

Vorzugsweise wird das Verfahren derart betrieben, dass die Hochspannung aufeinanderfolgend zunächst in einer ersten Phase mit einem ersten Pulsmuster betrieben wird und anschließend in einer zweiten Phase mit einem zweiten Pulsmuster betrieben wird, welches sich von dem ersten Pulsmuster - insbesondere in Pulslänge, Pulsdauer, Pulsanzahl und/oder Tastverhältnis - unterscheidet. Durch unterschiedliche Pulsmusters können dabei verschiedene Beschichtungscharakteristiken erzielt werden.

Der Aufbau eines Pulsmusters und insbesondere das Tastverhältnis bzw. die maximale Leistung sind wesentlich für die Beschaffenheit des Schichtaufbaus. Hohe Momentanleistungen führen zu einer starken gleichzeitigen Freisetzung von Zerfallsprodukten, sodass eine sehr homogene Schichtzunahme/homogenes Schichtwachstum erfolgen kann mit entsprechenden vorteilhaften mechanischen und barrieretechnischen Eigenschaften.

Vorzugsweise ist vorgesehen, dass das Magnetron während eines Pulses eine momentane Mikrowellenleistung (Momentanleistung) von zumindest 1.000 W, vorzugsweise mehr als 1.500 W, weiterhin vorzugsweise zumindest 3.000 W, insbesondere 7.000 W bis 15.000 W freisetzt. Bei einer entsprechend kurz gewählten Pulsdauer kann die Durchschnittsleistung - und die damit verbundene thermische Belastung - niedrig und insbesondere unter einem Wert von 750 W gehalten werden. Die momentane Mikrowellenleistung kann insbesondere auch über der Nennleistung des Magnetrons liegen.

Gemäß einer besonders bevorzugten Ausführungsform beträgt die mittlere Mikrowellenleistung - welche sich insbesondere aus der Momentanleistung und dem Tastverhältnis der Pulse ergibt - zumindest 5 W und nicht mehr als 600 W. Besonders bevorzugt beträgt die mittlere Mikrowellenleistung nicht mehr als 2/3, insbesondere nicht mehr als die Hälfte der Nennleistung des Magnetrons.

Vorzugsweise liegt die Hochspannung - welche an Anode und Kathode angelegt wird - zumindest 2.000 V, besonders bevorzugt zwischen 4.000 V und 5.000 V. Der während eines Pulses von der Anode zur Kathode fließende Anodenstrom beträgt insbesondere zwischen 100 mA und 1.200 mA.

Die Erfindung betrifft auch ein Magnetron mit einem durch eine Anode umschlossenen Hohlraum, mit einer in dem Hohlraum angeordneten Kathode, welche eine Heizeinrichtung aufweist, mit einer regelbaren Spannungsquelle, welche an die Heizeinrichtung angeschlossen ist und mit einer Steuerung. Erfindungsgemäß ist die Steuerung dazu eingerichtet, einen Sollwert für die Heizspannung zu bestimmen und die Spannungsversorgung derart anzusteuern, dass an der Heizeinrichtung der Sollwert der Heizspannung anliegt. Dieses erfindungsgemäße Magnetron weist gegenüber marktgängigen Exemplaren aus dem Stand der Technik eine deutlich erhöhte Lebenserwartung auf.

Zweckmäßigerweise weist das Magnetron eine mit der Steuerung gekoppelte Spannungsmesseinrichtung auf, welche an die Heizeinrichtung angeschlossen ist. Die Spannungsmesseinrichtung dient dazu, die an der Heizeinrichtung anliegende Heizspannung zu erfassen und der Steuerung nutzbar zu machen.

Ganz besonders bevorzugt ist die Spannungsquelle mit der Heizeinrichtung über Versorgungsleitungen verbunden. Um eine möglichst präzise und unverfälschte Spannungsmessung zu ermöglichen, ist die Spannungsmesseinrichtung ferner über von den Versorgungsleitungen separat ausgebildete Messleitungen angeschlossen.

Besonders bevorzugt ist die Spannungsmesseinrichtung in die Steuerung integriert. Hierbei kann es sich insbesondere um einen sogenannten Analogdigitalwandler (AD-Wandler) handeln. Dieser kann insbesondere in einer als integrierten Schaltkreis ausgebildete Steuerung eingebettet sein.

Die Erfindung betrifft auch eine Behälterbeschichtungsanlage zur Plasmabeschichtung von Behältern. Diese zeichnet sich durch ein zuvor beschriebenes Magnetron aus. Durch dessen erfindungsgemäße Vorteile ist ein besonders langer und daher kosteneffizienter Einsatz möglich.

Die Behälterbeschichtungsanlage weist ferner eine Reaktionskammer zur Aufnahme eines zu beschichtenden Behälters und eine das Magnetron mit der Reaktionskammer verbindenden Hochfrequenzleiter auf. Das Magnetron ist dazu eingerichtet nach dem erfindungsgemäßen Verfahren betrieben zu werden und gepulste Mikrowellenenergie über den Hochfrequenzleiter der Reaktionskammer zuzuleiten.

Die Erfindung wird nachfolgend anhand von lediglich Ausführungsbeispiele darstellenden Figuren erläutert. Es zeigen dabei schematisch:

Fig. 1       eine schematische Darstellung eines erfindungsgemäßen Magnetrons zu Durchführung des erfindungsgemäßen Verfahrens,

Fig. 2       ein beispielhafter Verlauf des Sollwerts im Rahmen eines erfindungsgemäßen Verfahrens gemäß einer ersten Ausführungsvariante,

Fig. 3A     ein beispielhafter Verlauf des Sollwerts und des Anodenstroms beim erfindungsgemäßen Verfahren gemäß einer zweiten Variante und

Fig. 3B ein beispielhafter Verlauf des Sollwerts und des Anodenstroms beim erfindungsgemäßen Verfahren gemäß einer dritten Variante.

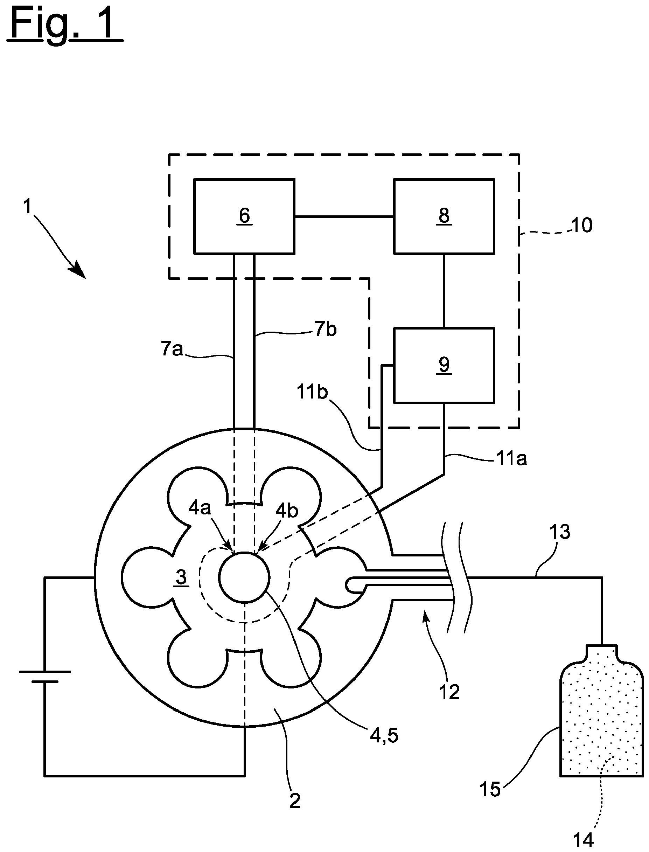

Die Fig. 1 zeigt ein erfindungsgemäßes Magnetron 1 mit einem durch eine Anode 2 umschlossenen Hohlraum 3, in dem eine eine Heizeinrichtung 4 aufweisende Kathode 5 angeordnet ist. Die Heizeinrichtung 4 ist als in das Material der Kathode 5 eingebettete Heizwendel ausgebildet und in der schematischen Figur nicht explizit dargestellt. Das Magnetron 1 weist ferner eine regelbare Spannungsquelle 6 auf, welche an die Heizeinrichtung 4 angeschlossen ist. Dazu ist die Heizeinrichtung 4 mit zwei Eingängen 4A, 4B ausgebildet, welche durch Versorgungsleitungen 7A, 7B mit der Spannungsquelle 6 elektrisch verbunden sind. Der ohmsche Innenwiderstand der Heizeinrichtung 4 und die Leitungswiderstände der Versorgungsleitungen 7A, 7B sind derart aufeinander abgestimmt, dass im Betrieb die ohmsche Verlustleistung im Wesentlichen vollständig innerhalb der Heizeinrichtung 4 abfällt.

Weiterhin ist eine Steuerung 8 vorgesehen, welche mit der variablen Spannungsquelle 6 steuernd verbunden ist. Erfindungsgemäß ist vorgesehen, dass ein Sollwert für eine an der Heizeinrichtung 4 zwischen den Eingängen 4A, 4B anliegende Heizspannung bestimmt wird und dass die Steuerung 8 die Spannungsquelle 6 derart ansteuert, dass an der Heizeinrichtung 4 der Sollwert der Heizspannung anliegt.

In dem dargestellten Ausführungsbeispiel ist weiterhin eine mit der Steuerung 8 gekoppelte Spannungsmesseinrichtung 9 vorgesehen, welche an die Heizeinrichtung 4 angeschlossen ist. Dabei sind die variable Spannungsversorgung 6, die Steuerung 8 und die Spannungsmesseinrichtung 9 in einer gemeinsamen Kontrolleinheit 10 miteinander verbunden.

Während die Spannungsquelle mit den Eingängen 4A, 4B der Heizeinrichtung 4 über Versorgungsleitungen 7A, 7B verbunden ist, wird die Spannungsmesseinrichtung 9 über von den Versorgungsleitungen 7A, 7B separat ausgebildete Messleitungen 11A, 11B angeschlossen.

In Fig. 1 ist außerdem angedeutet, dass ein Ausgang 12 an der Anode 2 des Magnetrons 1 ausgebildet ist, um die innerhalb des Magnetrons 1 erzeugten Mikrowellen auszukoppeln. Der Ausgang 12 ist dabei mit einem Wellenleiter 13 verbunden, um die Mikrowellen einer Verwendung zuzuführen. Lediglich schematisch ist angedeutet, dass die Mikrowellen in ein Plasma 14 eingekoppelt werden, welches zu Beschichtung eines Verpackungsbehälters 15 verwendet wird.

Nachfolgend werden verschiedene Varianten des erfindungsgemäßen Verfahrens erläutert. Da es sich bei dem Alterungsprozess um einen hinsichtlich des Betriebs gesehen zeitlichen Vorgang handelt, wird der Sollwert gemäß einer ersten Variante in Abhängigkeit von der Betriebszeit T des Magnetrons 1 und/oder der Heizeinrichtung 4 bestimmt.

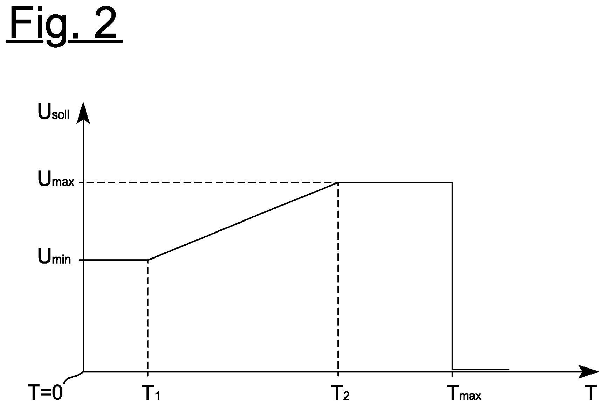

In dem gemäß Fig. 2 dargestellten Ausführungsbeispiel wird der Sollwert $U_{soll}$ bei Inbetriebnahme eines neuen Magnetrons 1 (T = 0) zunächst auf einen Minimalwert $U_{min}$ eingestellt. Dieser Minimalwert $U_{min}$ ist so berechnet, dass die dadurch hervorgerufene Heizleistung ausreicht, um bei einem neuen Magnetron 1 eine zuverlässige Zündung zu ermöglichen. Das Ausführungsbeispiel gemäß Fig. 2 sieht vor, dass der Sollwert $U_{soll}$ zunächst konstant bleibt bis zu einem ersten Zeitpunkt $T_1$. Ab diesem Zeitpunkt wird der Sollwert $U_{soll}$ linear interpolierend und bis zu einer Maximalspannung $U_{max}$ erhöht, welche an einem zweiten Zeitpunkt $T_2$ erreicht wird. Danach verbleibt der Sollwert $U_{soll}$ gleich auf dem Wert der Maximalspannung $U_{max}$, bis zu einem Zeitpunkt $T_{max}$ die maximale Lebensdauer des Magnetrons erreicht ist. An diesem Zeitpunkt ist eine zuverlässige Zündung des Magnetrons 1 nicht mehr möglich. Dabei wird das Magnetron 1 abgeschaltet und insbesondere der Sollwert $U_{soll}$ für die Heizspannung U auf Null gesetzt.

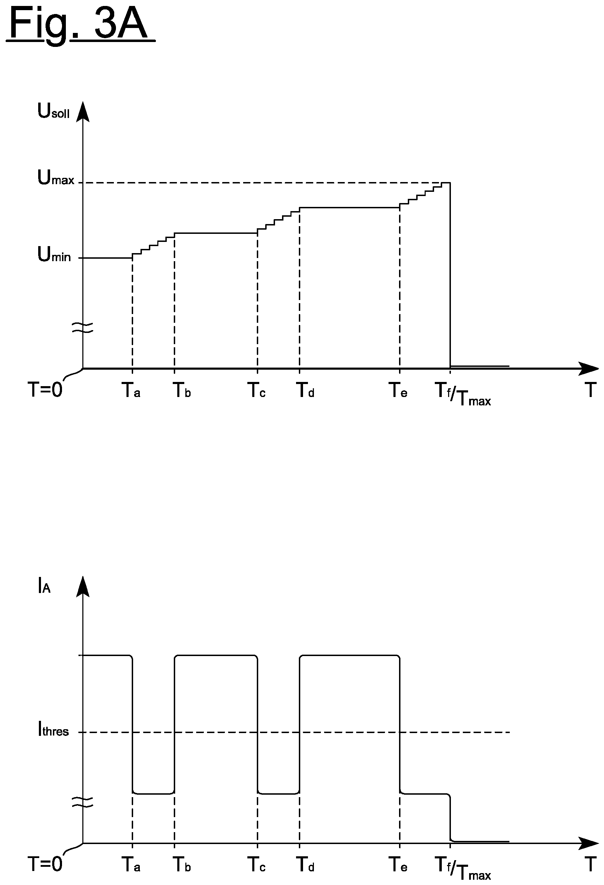

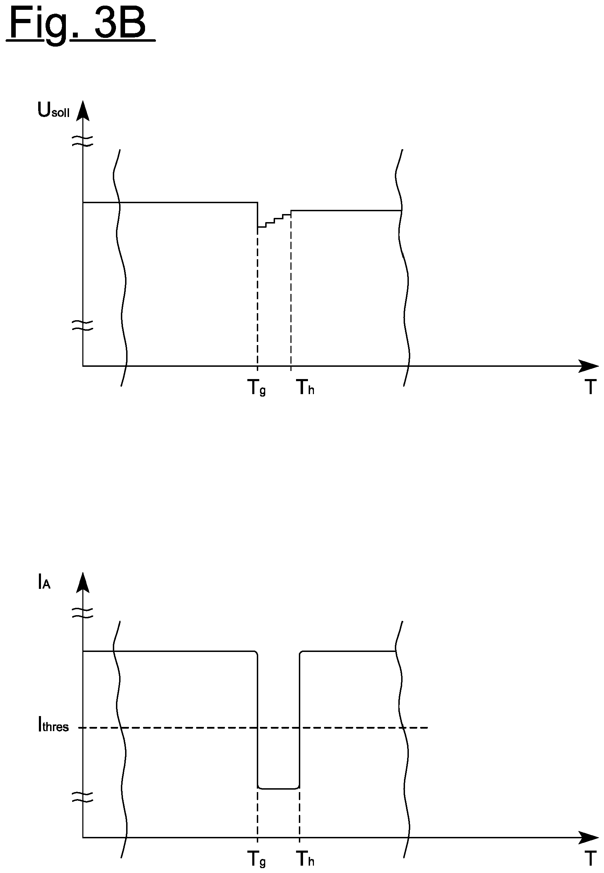

Die Fig. 3A und 3B zeigen Varianten, bei denen der Sollwert $U_{soll}$ nicht in vorbestimmter Weise erhöht wird, sondern überprüft und lediglich bedarfsgerecht gesteigert wird. Dazu ist in Fig. 3A dargestellt, dass zusätzlich der zwischen der Anode 2 und der Kathode 5 fließende Anodenstrom $I_A$ erfasst wird. Die dargestellten Verläufe für die Sollspannung $U_{soll}$ und den Anodenstrom $I_A$ sind dabei stark vereinfacht dargestellt.

Zu Beginn der Lebensdauer des Magnetrons 1 der Sollwert $U_{soll}$ zunächst auf die Minimalspannung $U_{min}$ eingestellt und während des Betriebs parallel der Anodenstrom $I_A$ erfasst. Durch zunehmenden Verschleiß verschlechtert sich mit fortschreitender Betriebszeit T das Emissionsverhalten der Kathode 5. In dem dargestellten Beispiel ist an einem ersten Zeitpunkt $T_a$ der Verschleiß derart groß, dass der Anodenstrom $I_A$ zusammenbricht und einen Schwellenwert $I_{thres}$ unterschreitet. Es kommt zu einem sogenannten Zündfehler des Magnetrons.

Um die Betriebsfähigkeit wiederherzustellen, wird in einem nachfolgenden Zeitraum eine Überprüfung durchgeführt. Dabei wird der Sollwert $U_{soll}$ stufenweise - mit einem Inkrement von 0,1 V - erhöht, bis an einem zweiten Zeitpunkt $T_b$ der Anodenstrom $I_A$ einen Schwellenwert $I_{thres}$ wieder überschreitet. Insbesondere auf der Zeitachse T sind die Verläufe nicht maßstäblich dargestellt. Insbesondere ist vorgesehen, dass der Zeitraum zwischen zwei aufeinanderfolgenden Überprüfungen bzw. Zündfehlern mehrere 100 Stunden beträgt. Das Zeitintervall zwischen einzelnen inkrementellen Spannungserhöhungen des Sollwerts $U_{soll}$ liegt im Bereich von einigen wenigen Sekunden, sodass eine Überprüfung idealer Weise in einem Zeitraum von weniger als einer Minute abgeschlossen ist. Hierdurch kann eine geringe Ausschussrate aufgrund von Zündfehlern erreicht werden.

In der Figur außerdem dargestellt, dass an einem dritten Zeitpunkt $T_c$ erneut ein Zündfehler auftritt. Nach diesem wird in gleicher Weise der Sollwert $U_{soll}$ erneut inkrementiert, bis an einem vierten Zeitpunkt $T_d$ das Magnetron 1 erneut zündet. In gleicher Weise können mehrere Überprüfungen über die Lebensdauer eines Magnetrons 1 durchgeführt werden. Bei diesen wird der Sollwert $U_{soll}$ der Heizspannung U immer nur im notwendigen Maße erhöht. Hierdurch lässt sich insgesamt die Lebensdauer des Magnetrons 1 maximieren.

In den Figuren ist außerdem dargestellt, dass an einem fünften Zeitpunkt $T_e$ erneut ein Zündfehler auftritt. Im Rahmen der nachfolgenden Überprüfung erreicht bzw. überschreitet der Sollwert $U_{soll}$ beim Inkrementieren die vorgesehene Maximalspannung $U_{max}$, ohne dass erneut die Zündung hergestellt werden kann. Damit wird festgestellt, dass das Magnetron 1 seine Lebensdauer erreicht hat und abgeschaltet werden muss. Infolgedessen werden der Sollwert $U_{soll}$ und vorzugsweise auch der Anodenstrom $I_A$ abgeschaltet bzw. auf Null gesetzt.

In der Fig. 3B ist eine weitere Möglichkeit für die Überprüfung des Sollwerts dargestellt. Diese kann alternativ oder zusätzlich zu den in Fig. 3A, durch einen Zündfehler ausgelösten, Überprüfungen vorgesehen sein. Bei der in Fig. 3B dargestellten Variante wird die Überprüfung des Sollwerts $U_{soll}$ zeitgesteuert, d. h. durch Erreichen einer Zeitspanne der Betriebsdauer T am Zeitpunkt $T_g$ ausgelöst. Zu dieser Zeit ist der Anodenstrom $I_A$ noch oberhalb des Schwellenwerts $I_{thres}$. Wie der Figur zu entnehmen ist, wird der Sollwert $U_{soll}$ zu Beginn der Überprüfung zunächst um einen Wert reduziert, sodass der Anodenstrom $I_A$ zusammenbricht. Anschließend wird der Sollwert wieder inkrementell gesteigert, bis die Zündung des Magnetrons am Zeitpunkt $T_h$ erfolgt. In dieser speziellen Variante ist es möglich, dass der Sollwert $U_{soll}$ nach der Überprüfung einen geringeren Wert aufweist als davor.

Bezugszeichenliste:

| | |
|---|---|
| 1 | Magnetron |
| 2 | Anode |
| 3 | Hohlraum |
| 4 | Heizeinrichtung |
| 5 | Kathode |
| 6 | Spannungsquelle |
| 7A, 7B | Versorgungsleitungen |
| 8 | Steuerung |
| 9 | Spannungsmesseinrichtung |
| 10 | Kontrolleinheit |
| 11A, 11B | Messleitungen |
| 12 | Ausgang |
| 13 | Wellenleiter |
| 14 | Plasma |
| 15 | Verpackungsbehälter |
| $U_{soll}$ | Sollwert |
| $U_{min}$ | Minimalwert |
| $U_{max}$ | maximale Spannung |
| $I_{thres}$ | Schwellenwert |
| IA | Anodenstrom |
| T | Betriebszeit |
| $T_a$ | erster Zeitpunkt |
| $T_b$ | zweiter Zeitpunkt |
| $T_c$ | dritter Zeitpunkt |
| $T_d$ | vierter Zeitpunkt |
| $T_e$ | fünfter Zeitpunkt |
| $T_g$ | Zeitpunkt |
| $T_h$ | Zeitpunkt |

**Patentansprüche**

1. Verfahren zum Betrieb eines Magnetrons (1) mit einem durch eine Anode (2) umschlossenen Hohlraum (3), mit einer in dem Hohlraum (3) angeordneten Kathode (5), welche eine Heizeinrichtung (4), insbesondere einen Heizdraht, aufweist, mit einer regelbaren Spannungsquelle (6), welche an die Heizeinrichtung (4) angeschlossen ist und mit einer Steuerung (8), **dadurch gekennzeichnet, dass** ein Sollwert für eine an der Heizeinrichtung (4) anliegende Heizspannung (U) bestimmt wird und dass die Steuerung (8) die Spannungsquelle (6) derart ansteuert, dass an der Heizeinrichtung (4) der Sollwert ($U_{soll}$) für die Heizspannung (U) anliegt.

2. Verfahren nach einem der vorangegangenen Ansprüche, **dadurch gekennzeichnet, dass** die Steuerung (8) eine Einheit zur Erfassung der Betriebszeit (T) des Magnetrons (1) und/oder der Heizeinrichtung (4) aufweist und dass der Sollwert ($U_{soll}$) in Abhängigkeit von der Betriebszeit (T) bestimmt wird.

3. Verfahren nach einem der vorangegangenen Ansprüche, **dadurch gekennzeichnet, dass** der Sollwert ($U_{soll}$) von einem Minimalwert ($U_{min}$) ausgehend festgelegt wird.

4. Verfahren nach einem der vorangegangenen Ansprüche, **dadurch gekennzeichnet, dass** der Sollwert ($U_{soll}$) zumindest abschnittsweise als lineare Funktion der Betriebszeit (T) bestimmt wird.

5. Verfahren nach einem der vorangegangenen Ansprüche, **dadurch gekennzeichnet, dass** der Sollwert ($U_{soll}$) in festgelegten Zeitintervallen vergrößert wird.

6. Verfahren nach einem der vorangegangenen Ansprüche, **dadurch gekennzeichnet, dass** der Sollwert ($U_{soll}$) nach dem Eintreten eines auslösenden Ereignisses erhöht und/oder überprüft und bedarfsgerecht erhöht wird.

7. Verfahren nach Anspruch 6, **dadurch gekennzeichnet, dass** das auslösende Ereignis durch ein externes Ereignis realisiert ist, insbesondere durch eine Benutzereingabe und/oder eine externe Ansteuerung ist.

8. Verfahren nach Anspruch 6 oder 7, **dadurch gekennzeichnet, dass** das auslösende Ereignis durch das Erreichen eines Schwellenwerts der Betriebszeit (T) realisiert ist.

9. Verfahren nach einem der vorangegangenen Ansprüche 6 bis 8, **dadurch gekennzeichnet, dass** das auslösende Ereignis durch das Erreichen eines Zeitintervalls an Betriebszeit (T) seit der letzten Überprüfung und/oder der letzten Erhöhung des Sollwerts ($U_{soll}$) realisiert ist.

10. Verfahren nach einem der vorangegangenen Ansprüche 6 bis 9, **dadurch gekennzeichnet, dass** ein Stromfluss zwischen der Anode (2) und der Kathode (5), der Anodenstrom ($I_A$) erfasst wird und dass der Auslöser das Unterschreiten eines Schwellenwerts ($I_{thres}$) beim Anodenstrom ($I_A$) ist.

11. Verfahren nach einem der vorangegangenen Ansprüche, **dadurch gekennzeichnet, dass** der Sollwert ($U_{soll}$) erhöht wird, bis der Anodenstrom ($I_A$) den Schwellenwert ($I_{thres}$) erreicht oder überschreitet.

12. Verfahren nach einem der vorangegangenen Ansprüche, **dadurch gekennzeichnet, dass** der Sollwert ($U_{soll}$) in der Steuerung gespeichert und zwischen zwei aufeinanderfolgenden Überprüfungen verwendet wird

13. Verfahren nach einem der vorangegangenen Ansprüche, **dadurch gekennzeichnet, dass** nach einem Auslöser zunächst der Sollwert ($U_{soll}$), insbesondere um einen Betrag zwischen 0,1 V und 5 V, reduziert wird.

14. Verfahren nach einem der vorangegangenen Ansprüche, **dadurch gekennzeichnet, dass** der Sollwert ($U_{soll}$) einen minimalen Wert $U_{min}$, insbesondere etwa 1 V, nicht unterschreitet.

15. Verfahren nach einem der vorangegangenen Ansprüche, **dadurch gekennzeichnet, dass** der Sollwert ($U_{soll}$) nicht über eine maximale Spannung ($U_{max}$) erhöht wird.

16. Verfahren nach einem der vorangegangenen Ansprüche, **dadurch gekennzeichnet, dass** bei Unterschreiten eines Schwellenwerts ($I_{thres}$) für den Anodenstrom ($I_A$) und Erreichen des Maximalwerts ($U_{max}$) durch den Sollwert ($U_{soll}$) das Magnetron (1) abgeschaltet wird.

17. Verfahren nach einem der vorangegangenen Ansprüche, **dadurch gekennzeichnet, dass** das Magnetron (1) über einen Ausgang (12) Mikrowellenstrahlung an ein Plasma (14), insbesondere für ein Plasmabeschichtungsverfahren, ganz besonders bevorzugt zur Plasmabeschichtung von Behältern (15) abgibt.

18. Magnetron (1) mit einem durch eine Anode (2) umschlossenen Hohlraum (3), mit einer in dem Hohlraum (3) angeordneten Kathode (5), welche eine Heizeinrichtung (4) aufweist, mit einer regelbaren Spannungsquelle (6), welche mit der Heizeinrichtung (4) verbunden ist und mit einer Steuerung (8), **dadurch gekennzeichnet, dass** die Steuerung (8) dazu eingerichtet ist, einen Sollwert ($U_{soll}$) für eine Heizspannung (U) zu bestimmen und die Spannungsversorgung (6) derart anzusteuern, dass an der Heizeinrichtung (4) der Sollwert ($U_{soll}$) der Heizspannung (U) anliegt.

19. Magnetron (1) nach Anspruch 18, **gekennzeichnet durch** eine mit der Steuerung (8) gekoppelte Spannungsmesseinrichtung (9), welche an die Heizeinrichtung (4) angeschlossen ist.

20. Magnetron (1) nach einem der vorangegangenen Ansprüche 18 oder 19, **dadurch gekennzeichnet, dass** die Spannungsquelle (6) mit der Heizeinrichtung (4) über Versorgungsleitungen (7A, 7B) verbunden ist und dass die Spannungsmesseinrichtung (9) über von den Versorgungsleitungen (7A, 7B) separat ausgebildete Messleitungen (11A, 11B) angeschlossen ist.

21. Magnetron (1) nach einem der vorstehenden Ansprüche 18 bis 20, **dadurch gekennzeichnet, dass** die Spannungsmesseinrichtung (9) in die Steuerung (8) integriert ist.

22. Behälterbeschichtungsanlage zur Plasmabeschichtung von Behältern (15), **gekennzeichnet durch** ein Magnetron (1) gemäß einem der Ansprüche 18 bis 21.

# Fig. 1

# Fig. 2

# Fig. 3A

# Fig. 3B

Europäisches
Patentamt

European
Patent Office

Office européen
des brevets

## EUROPÄISCHER RECHERCHENBERICHT

**Nummer der Anmeldung**

EP 24 18 4073

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2008/309239 A1 (KASAI SHIGERU [JP] ET AL) 18. Dezember 2008 (2008-12-18) | 1-21 | INV. H01J37/32 H05B6/64 |
| Y | * Absatz [0002] *<br>* Absatz [0041] - Absatz [0042] *<br>* Absatz [0046]; Abbildungen 2-7 *<br>* Absatz [0057] - Absatz [0058] *<br>* Absatz [0062] - Absatz [0064] *<br>* Absätze [0066], [0067], [0069] *<br>* Absatz [0072] - Absatz [0102] *<br>* Absatz [0016] - Absatz [0021] *<br>----- | 22 | |
| Y | US 2023/110364 A1 (NISHIYAMA MASANORI [JP] ET AL) 13. April 2023 (2023-04-13)<br>* Abbildung 1 *<br>----- | 22 | |
| Y | DE 10 2016 117926 A1 (RATIONAL AG [DE]) 22. März 2018 (2018-03-22)<br>* Absatz [0001] *<br>* Absatz [0008] - Absatz [0011] *<br>* Absatz [0024] - Absatz [0028] *<br>----- | 1,18 | |
| Y | US 2014/263202 A1 (PARTRIDGE GUTHRIE [US]) 18. September 2014 (2014-09-18)<br>* Abbildungen 1A, 1B, 2A, 2B, 4 *<br>----- | 1,18 | **RECHERCHIERTE SACHGEBIETE (IPC)**<br><br>H01J |

Der vorliegende Recherchenbericht wurde für alle Patentansprüche erstellt

| Recherchenort | Abschlußdatum der Recherche | Prüfer |
|---|---|---|
| Den Haag | 31. Oktober 2024 | Hochstrasser, M |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

...........................................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 24 18 4073

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

31-10-2024

| Im Recherchenbericht angeführtes Patentdokument | Datum der Veröffentlichung | Mitglied(er) der Patentfamilie | Datum der Veröffentlichung |
|---|---|---|---|
| US 2008309239 A1 | 18-12-2008 | CN 101107693 A | 16-01-2008 |
| | | CN 101788638 A | 28-07-2010 |
| | | JP 2007073395 A | 22-03-2007 |
| | | KR 20080038395 A | 06-05-2008 |
| | | US 2008309239 A1 | 18-12-2008 |
| | | WO 2007029580 A1 | 15-03-2007 |
| US 2023110364 A1 | 13-04-2023 | AU 2021243406 A1 | 20-10-2022 |
| | | BR 112022019126 A2 | 08-11-2022 |
| | | CA 3176927 A1 | 30-09-2021 |
| | | CN 115298353 A | 04-11-2022 |
| | | EP 4130336 A1 | 08-02-2023 |
| | | JP 7538855 B2 | 22-08-2024 |
| | | JP WO2021193651 A1 | 30-09-2021 |
| | | KR 20220157958 A | 29-11-2022 |
| | | TW 202208244 A | 01-03-2022 |
| | | US 2023110364 A1 | 13-04-2023 |
| | | WO 2021193651 A1 | 30-09-2021 |
| DE 102016117926 A1 | 22-03-2018 | KEINE | |
| US 2014263202 A1 | 18-09-2014 | CN 104064428 A | 24-09-2014 |
| | | DE 102014202540 A1 | 18-09-2014 |
| | | GB 2513439 A | 29-10-2014 |
| | | JP 6329787 B2 | 23-05-2018 |
| | | JP 2014183049 A | 29-09-2014 |
| | | US 2014263202 A1 | 18-09-2014 |

EPO FORM P0461

Für nähere Einzelheiten zu diesem Anhang : siehe Amtsblatt des Europäischen Patentamts, Nr.12/82